# FASCICULE DE BREVET EUROPEEN

(11) **EP 3 851 352 B1**
(45) Date de publication et mention de la délivrance du brevet: **15.06.2022**
(21) Numéro de dépôt: 21151850.1
(22) Date de dépôt: 15.01.2021
(51) Int. Cl.: B61C 17/04, B61D 27/00, B61D 33/00, B61D 37/00, H05K 5/02, H05K 7/20

(54) **VÉHICULE, NOTAMMENT FERROVIAIRE, COMPRENANT UN COFFRE MUNI D'UNE JUPE DE COUVERTURE**
FAHRZEUG, INSBESONDERE SCHIENENFAHRZEUG, DAS EINEN MIT EINER ABDECKSCHÜRZE VERSEHENEN KASTEN UMFASST
VEHICLE, IN PARTICULAR A RAILWAY VEHICLE, COMPRISING A BOX PROVIDED WITH A COVERING SKIRT

(30) Priorité: 17.01.2020 FR 2000434
(43) Date de publication de la demande: 21.07.2021
(73) Titulaire: ALSTOM Transport Technologies, 93400 Saint-Ouen (FR)
(72) Inventeur: RAVOT, Julien-Gabriel, 01500 Ambérieu en Bugey (FR); CHAUPRADE, Romain, 78800 Houilles (FR); ACKERMANN, Martial Denis Jacky, 67350 Pfaffenhoffen (FR); RAMBAUD, Adrien, 67110 Uttenhoffen (FR)
(74) Mandataire: Lavoix

(56) Documents cités:
- JP-U- S5 785 354
- JP-U- S6 332 062
- JP-U- S60 157 469
- US-A- 1 813 218

## Description

La présente invention concerne un véhicule ferroviaire, de type comprenant un plancher et un coffre reposant sur le plancher, le coffre comprend des parois latérales, au moins l'une des parois latérales étant munie d'une ouverture d'entrée d'air.

Un véhicule de transport en commun, notamment ferroviaire, comprend des composants électroniques nécessaires à son fonctionnement. Ces composants électroniques sont, au moins en partie, disposés dans des coffres disposés sous les sièges des voitures accueillant des passagers.

En fin de service, ces véhicules sont nettoyés à grande eau ; ces coffres doivent donc être protégés contre les projections de liquide.

Les composants électroniques dégagent, en fonctionnement, un important flux de chaleur. Or, ces composants présentent des difficultés de fonctionnement et risquent de casser lorsqu'ils sont soumis à des températures excessives. Ils doivent donc être refroidis par des dispositifs appropriés. Une solution pour réguler la température à l'intérieur des coffres est de créer une circulation d'air entre l'extérieur et l'intérieur de chaque coffre afin d'évacuer l'air chaud. Lors d'un nettoyage du train, un jet d'eau dirigé vers le coffre peut pénétrer par toute ouverture non protégée pratiquée dans les parois du coffre et ainsi endommager les équipements électroniques qu'il contient.

Le document FR 3 063 178 A1 décrit un coffre pour véhicule ferroviaire destiné à recevoir des composants électroniques. Ce coffre comprend une porte comportant une double paroi verticale, qui comprend deux parois s'étendant en vis-à-vis l'une de l'autre et séparées par une lame d'air. Cette double paroi définit une entrée d'air et une sortie d'air, permettant une circulation de l'air entre l'entrée et la sortie. Le conduit de circulation d'air forme une chicane permettant à l'air de circuler entre l'extérieur et l'intérieur du coffre. L'entrée et la sortie du conduit sont situées au niveau d'une face du coffre. Ceci a pour inconvénient, lors d'un nettoyage du train avec un jet d'eau, de laisser entrer l'eau dans le coffre par l'entrée et la sortie d'air, ce qui risque d'endommager les composants électroniques qui s'y trouvent. Le document JPS60157469U décrit également un coffre pour véhicule ferroviaire. Ce coffre est destiné à être installé dans le compartiment voyageur et ne présente comme protection contre les jets d'eau qu'une feuille de métal inclinée déviant ces éventuels jets d'eau vers le haut.

L'invention a pour but de proposer un coffre de véhicule ferroviaire permettant un nettoyage à l'eau du sol sans risque pour les éléments disposés dans le coffre.

A cet effet l'invention a pour objet un véhicule ferroviaire de type précité. Selon l'invention, le coffre comporte une jupe pleine de couverture de l'ouverture d'entrée d'air s'étendant, en regard de toute la surface de l'ouverture d'entrée d'air et à l'écart de celle-ci, parallèlement au plan de l'ouverture d'entrée d'air.

Grâce à l'invention, la jupe de couverture recouvre entièrement l'ouverture d'entrée d'air. Ainsi, si un jet d'eau est dirigé vers l'ouverture d'entrée d'air, il est arrêté par la jupe de couverture et l'eau ne peut pas pénétrer à l'intérieur du coffre.

Selon des aspects avantageux mais non obligatoires de l'invention, un tel coffre comporte une ou plusieurs des caractéristiques suivantes prises selon toutes combinaisons techniquement admissibles :
- Le véhicule comporte des voussoirs formés de profilés creux, le coffre étant muni d'une ouverture de sortie d'air communiquant avec les voussoirs.
- Le coffre comprend une chicane d'entrée d'air et chaque voussoir comprend une sortie d'air, une distance entre chaque sortie d'air et le plancher du véhicule étant supérieure à une distance entre la chicane d'entrée d'air et le plancher du véhicule.
- Le coffre comprend un capotage de guidage d'un flux d'air entrant dans le coffre par ladite au moins une ouverture d'entrée d'air.
- L'ouverture d'entrée d'air est munie d'un filtre.
- Le coffre comprend une porte ménagée dans une paroi latérale, l'ouverture d'entrée d'air étant située sur la porte et la jupe de couverture étant montée sur la porte.
- Au moins deux parois latérales sont munies d'ouvertures d'entrée d'air.
- La jupe de couverture comporte un panneau plein comprenant au moins deux portions, chacune de ces portions s'étendant parallèlement à l'une des parois latérales munies d'ouvertures d'entrée d'air.
- La jupe de couverture comprend une bordure, reliant la ou chaque portion du panneau plein à la paroi latérale munie de l'ouverture d'entrée d'air correspondante, la bordure s'étendant sur l'étendue de toute la ou chaque ouverture d'entrée d'air.
- Le coffre est surmonté d'au moins un siège.

L'invention sera mieux comprise et d'autres avantages de celles-ci apparaîtront plus clairement à la lumière de la description qui va suivre d'un mode de réalisation d'un véhicule ferroviaire, donnée uniquement à titre d'exemple et faite en référence aux dessins, dans lesquels :
[Fig 1] la figure 1 est une vue schématique en perspective d'une partie d'un véhicule ferroviaire comprenant un coffre conforme à l'invention ;
[Fig 2] la figure 2 est une vue schématique de côté du véhicule de la figure 1, une paroi du coffre ayant été retirée ; et

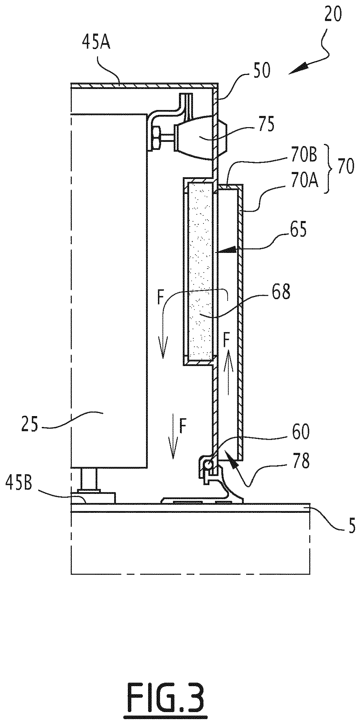

[Fig 3] la figure 3 est une vue schématique en coupe d'une partie du coffre de la figure 1.

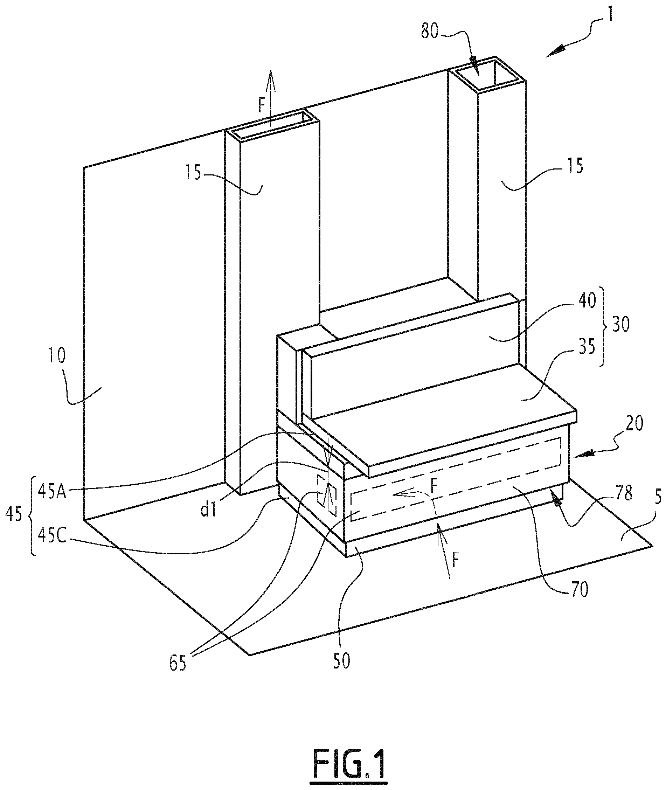

Un véhicule ferroviaire 1, par exemple un train ou un tramway, illustré en partie sur la figure 1, comprend un plancher 5 et des parois latérales 10 retenues par des voussoirs verticaux 15. Les voussoirs 15 s'étendent du plancher 5 du véhicule à un plafond non représenté. Ils sont formés par des profilés creux. Dans l'exemple des figures, chaque voussoir 15 a la forme d'un cylindre creux, l'un ayant une section rectangulaire et l'autre une section carrée.

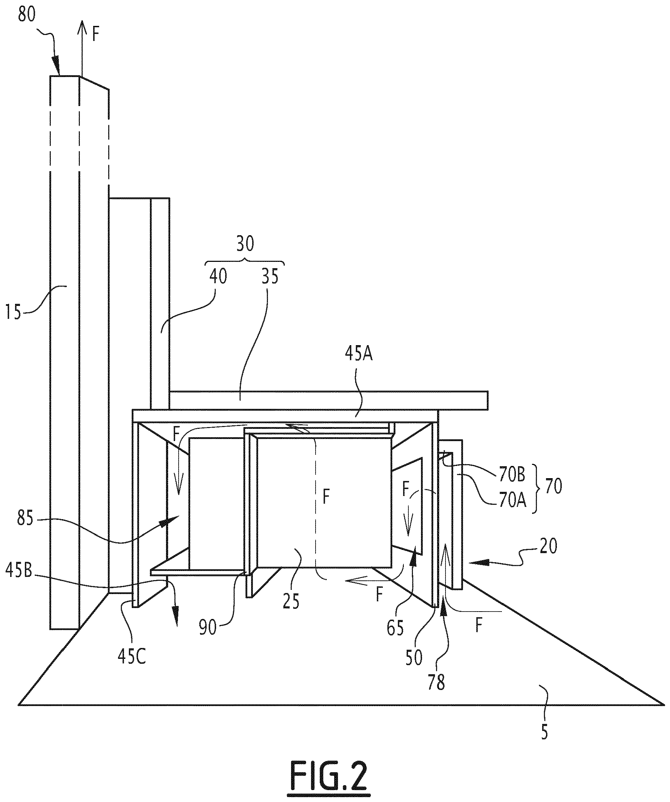

Le véhicule 1 comporte un coffre 20 reposant sur le plancher 5. Le coffre 20 est disposé contre l'une des parois latérales 10 du véhicule 1, entre deux voussoirs 15. Le coffre 20 comporte intérieurement des composants électroniques 25, mieux visibles sur la figure 2. Le coffre 20 est surmonté d'un siège 30 comprenant une assise 35 et un dossier 40.

Le coffre 20 a la forme d'un pavé qui comprend un plafond 45A, un fond 45B et des parois latérales 45C. Les parois latérales 45C forment chacune un plan orthogonal au plancher 5.

Le fond 45B du coffre 20 est formé par le plancher 5 du véhicule 1.

L'une des parois latérales 45C dite paroi avant et parallèle à la paroi latérale 10 d'appui du siège 30 comprend une porte 50.

Cette porte 50 est avantageusement déposée pour permettre d'accéder aux équipements que le coffre 20 contient. Un joint 60 assure l'étanchéité entre la porte 50 et le coffre 20.

La porte 50 et les parois latérales 45C qui sont adjacentes à la porte 50 sont munies, chacune, d'une ouverture d'entrée d'air 65 représentée en pointillés sur la figure 1. Ainsi, chaque ouverture d'entrée d'air 65 est située dans l'un des plans orthogonaux au plancher 5 formés par les parois latérales 45C et la porte 50.

L'ouverture d'entrée d'air 65 située sur la porte 50 du coffre 20 occupe par exemple entre 40% et 70%, de préférence 50%, de la surface de la paroi avant 45C.

La porte 50 inclut également un filtre déposable 68 qui recouvre l'ouverture d'entrée d'air 65 et qui permet d'éviter toute entrée de poussière ou de nuisibles dans le coffre 20. La capacité de filtration de ce filtre est adaptée au débit d'air en convection naturelle généré dans le coffre 20. L'épaisseur de ce filtre 68 est conçue pour garantir la compacité du système total, et sa fixation autorise un changement aisé et sans outil.

Le filtre 68 est fixé à la porte 50 et dirigé vers l'intérieur du coffre 20. De préférence, le filtre 68 est séparé des composants électroniques 25 par une lame d'air.

Le coffre 20 comporte pour chaque ouverture d'entrée d'air 65 une jupe pleine de couverture 70 qui la recouvre totalement. La jupe 70 s'étend, en regard et parallèlement aux ouvertures d'entrée d'air 65, sur toute leur surface.

La porte 50 comporte un système de verrouillage 75, notamment une serrure, qui la verrouille dans une position fermée.

La jupe 70 comporte un panneau plein 70A comprenant trois portions, chacune s'étendant parallèlement à l'une des parois latérales 45C munies d'ouvertures d'entrée d'air 65. La jupe 70 comprend également une bordure 70B supérieure continue s'étendant sur l'étendue de chaque ouverture 65. La bordure 70B relie chaque portion du panneau plein 70A à la paroi latérale 45C munie de l'ouverture 65 correspondante. En pratique, la bordure 70B s'étend sur toute la largeur des parois latérales 45C sur lesquelles les ouvertures d'entrée d'air 65 se trouvent.

Une extrémité supérieure de chaque ouverture d'entrée d'air 65 est située à une distance d1 non nulle du plafond 45A du coffre 20, mesurée perpendiculairement au plafond 45A. La bordure 70B est fixée à au moins l'une des parois latérales 45C auxquelles elle est liée entre l'extrémité supérieure de l'ouverture d'entrée d'air 65 correspondante et le plafond 45A. En pratique, la jupe 70 est fixée à la porte 50.

La jupe de couverture 70 recouvrant la totalité de chaque ouverture d'entrée d'air 65, elle forme avantageusement, avec une extrémité inférieure de chaque ouverture 65, une chicane d'entrée d'air 78.

Des sorties d'air 80 sont ménagées dans les voussoirs 15 et une ouverture de sortie d'air 85 est ménagée dans la paroi latérale 45A opposée à la porte 50, qui est en contact avec les voussoirs 15. Ainsi, l'ouverture de sortie d'air 85 communique avec les voussoirs 15.

Sur la figure 1, deux voussoirs 15 sont représentés, chacun définissant une sortie d'air 85.

L'intérieur du coffre 20 comprend un capotage intérieur 90 de guidage d'un flux d'air F.

Le flux d'air F froid, venant de l'extérieur du coffre 20, pénètre dans le coffre 20 par les ouvertures d'entrée d'air 65 après être passé dans la chicane 78.

Le flux d'air F est ensuite guidé par le capotage 90 dans le coffre 20 pour traverser les composants électroniques 25, qui sont ainsi refroidis.

Finalement, le flux d'air F, chauffé par les composants électroniques 25, traverse l'ouverture de sortie 85 pour s'élever dans les voussoirs vers les sorties d'air 80.

Les sorties d'air 80 étant situées à une distance du plancher 5 supérieure à la distance séparant la chicane d'entrée d'air 78 du plancher 5, la différence entre la température de l'air situé à l'extérieur du coffre 20 et la température de l'air aux sorties d'air 80 crée un effet cheminée qui contraint le flux d'air F à toujours circuler de la chicane d'entrée d'air 78 aux sorties d'air 80.

Le recouvrement total des ouvertures d'entrée d'air 65 par la jupe de couverture 70 permet d'éviter toute pénétration d'eau dans le coffre 20 lors d'une opération de nettoyage du véhicule 1 avec un jet d'eau et toute introduction frauduleuse d'objets à l'intérieur du coffre 20 par les ouvertures d'entrée d'air 65.

En variante, le siège 30 repose sur un support dédié et le coffre 20 est situé ailleurs dans le véhicule 1, par exemple entre deux sièges 30.

En variante, le véhicule 1 comprend deux coffres 20 ou plus.

Selon une autre variante, le coffre 20 supporte plus d'un siège 30, par exemple deux sièges 30 ou trois sièges 30.

En variante, la bordure 70B de chaque panneau 70 est fixée dans le prolongement du plafond 45B.

## Revendications

1. Véhicule (1) ferroviaire comprenant un plancher (5) et un coffre (20) reposant sur le plancher, le coffre comprend des parois latérales (45C), au moins l'une des parois latérales étant munie d'une ouverture d'entrée d'air (65), **caractérisé en ce que** le coffre comporte une jupe pleine de couverture (70) de l'ouverture d'entrée d'air s'étendant, en regard de toute la surface de l'ouverture d'entrée d'air et à l'écart de celle-ci, parallèlement au plan de l'ouverture d'entrée d'air, et **en ce que** le véhicule comporte des voussoirs (15) formés de profilés creux, le coffre (20) étant muni d'une ouverture de sortie d'air (85) communiquant avec les voussoirs.

2. Véhicule (1) selon la revendication 1, dans lequel le coffre (20) comprend une chicane d'entrée d'air (78) et chaque voussoir (15) comprend une sortie d'air (80), une distance entre chaque sortie d'air et le plancher (5) du véhicule étant supérieure à une distance entre la chicane d'entrée d'air et le plancher du véhicule.

3. Véhicule (1) selon l'une quelconque des revendications précédentes, dans lequel le coffre (20) comprend un capotage (90) de guidage d'un flux d'air (F) entrant dans le coffre par ladite au moins une ouverture d'entrée d'air (65).

4. Véhicule (1) selon l'une quelconque des revendications précédentes, dans lequel l'ouverture d'entrée d'air (65) est munie d'un filtre (68).

5. Véhicule (1) selon l'une quelconque des revendications précédentes, dans lequel le coffre (20) comprend une porte (50) ménagée dans une paroi latérale (45C), l'ouverture d'entrée d'air étant située sur la porte et la jupe de couverture (70) étant montée sur la porte.

6. Véhicule (1) selon l'une quelconque des revendications précédentes, dans lequel au moins deux parois latérales (45C) sont munies d'ouvertures d'entrée d'air (65).

7. Véhicule (1) selon la revendication 6, dans lequel la jupe de couverture (70) comporte un panneau plein (70A) comprenant au moins deux portions, chacune de ces portions s'étendant parallèlement à l'une des parois latérales (45C) munies d'ouvertures d'entrée d'air (65).

8. Véhicule (1) selon la revendication 7, dans lequel la jupe de couverture (70) comprend une bordure (70B), reliant la ou chaque portion du panneau plein (70A) à la paroi latérale (45C) munie de l'ouverture d'entrée d'air (65) correspondante, la bordure s'étendant sur l'étendue de toute la ou chaque ouverture d'entrée d'air.

9. Véhicule (1) selon l'une quelconque des revendications précédentes, dans lequel le coffre (20) est surmonté d'au moins un siège (30).

## Patentansprüche

1. Schienenfahrzeug (1), umfassend einen Boden (5) und einem auf dem Boden aufliegenden Kasten (20), der Kasten umfassend Seitenwände (45C), wobei mindestens eine der Seitenwände mit einer Lufteintrittsöffnung (65) versehen ist, **dadurch gekennzeichnet, dass** der Kasten eine massive Abdeckschürze (70) der Lufteintrittsöffnung umfasst, die sich gegenüber der gesamten Oberfläche der Lufteintrittsöffnung und davon beabstandet parallel zu der Ebene der Lufteintrittsöffnung erstreckt, und dass das Fahrzeug Wölbungen (15) umfasst, die aus Hohlprofilen gebildet sind, wobei der Kasten (20) mit einer Luftaustrittsöffnung (85) versehen ist, die mit den Wölbungen in Verbindung sind.

2. Fahrzeug (1) nach Anspruch 1, wobei der Kasten (20) eine Lufteinlassblende (78) umfasst und jede Wölbung (15) einen Luftauslass (80) umfasst, wobei ein Abstand zwischen jedem Luftauslass und dem Boden (5) des Fahrzeugs größer ist als ein Abstand zwischen der Lufteinlassblende und dem Boden des Fahrzeugs.

3. Fahrzeug (1) nach einem der vorherigen Ansprüche, wobei der Kasten (20) eine Abdeckung (90) zum Leiten eines Luftstroms (F) umfasst, der durch die mindestens eine Lufteinlassöffnung (65) in den Kasten eintritt.

4. System (1) nach einem der vorherigen Ansprüche, wobei die Lufteinlassöffnung (65) mit einem Filter (68) versehen ist.

5. Fahrzeug (1) nach einem der vorherigen Ansprüche, wobei der Kasten (20) eine Tür (50) umfasst, die in einer Seitenwand (45C) angeordnet ist, wobei sich die Lufteinlassöffnung an der Tür befindet und die Abdeckschürze (70) an der Tür montiert ist.

6. Fahrzeug (1) nach einem der vorherigen Ansprüche, wobei mindestens zwei Seitenwände (45C) mit Lufteinlassöffnungen (65) versehen sind.

7. Fahrzeug (1) nach Anspruch 6, wobei die Abdeckschürze (70) eine feste Platte (70A) mit mindestens zwei Abschnitten umfasst, wobei sich jeder dieser Abschnitte parallel zu einer der Seitenwände (45C) erstreckt, die mit Lufteinlassöffnungen (65) versehen sind.

8. Fahrzeug (1) nach Anspruch 7, wobei die Abdeckschürze (70) einen Rand (70B) umfasst, der den oder jeden Abschnitt der massiven Platte (70A) mit der Seitenwand (45C) verbindet, die mit der jeweiligen Lufteinlassöffnung (65) versehen ist, wobei sich der Rand über die Erstreckung der gesamten oder jeder Lufteinlassöffnung erstreckt.

9. Fahrzeug (1) nach einem der vorherigen Ansprüche, wobei auf dem Kasten (20) mindestens ein Sitz (30) montiert ist.

## Claims

1. Rail vehicle (1) comprising a floor (5) and a box (20) supported by the floor. The box includes side walls (45C), at least one of the side walls being equipped with an air inlet opening (65), **characterized in that** the box has a solid skirt (70) covering the air inlet opening extending, facing the entire surface of the air inlet opening and away from the air inlet opening, parallel to the plane of the air inlet opening, and **in that** the vehicle comprises wall panels (15) formed of hollow sections, the box (20) being equipped with an air outlet opening (85) communicating with the wall panels.

2. Vehicle (1) as claimed in claim 1, wherein the box (20) includes an air inlet baffle (78) and each wall panel (15) includes an air outlet (80), a distance between each air outlet and the vehicle floor (5) being greater than a distance between the air inlet baffle and the vehicle floor.

3. Vehicle (1) as claimed in any of the preceding claims, wherein the box (20) includes a cowling (90) for guiding the air flow (F) entering the box through at least one such air inlet opening (65).

4. Vehicle (1) as claimed in any of the preceding claims, wherein the air inlet opening (65) is equipped with a filter (68).

5. Vehicle (1) as claimed in any of the preceding claims, wherein the box (20) has a door (50) in a side wall (45C), the air inlet opening being located on the door and the cover skirt (70) being mounted on the door.

6. Vehicle (1) as claimed in any of the preceding claims, wherein at least two side walls (45C) are equipped with air inlet openings (65).

7. Vehicle (1) as claimed in claim 6, wherein the cover skirt (70) includes a solid panel (70A) comprising at least two portions, each of those portions extending parallel to one of the side walls (45C) equipped with air inlet openings (65).

8. Vehicle (1) as claimed in claim 7, wherein the cover skirt (70) includes a border (70B), connecting the or each portion of the solid panel (70A) to the side wall (45C) equipped with the corresponding air inlet opening (65), the border extending over the entire surface area of the or each air inlet opening.

9. Vehicle (1) as claimed in any of the preceding claims, wherein the box (20) is located beneath at least one seat (30).
